# EUROPEAN PATENT SPECIFICATION

(11) **EP 2 518 424 B1**
(45) Date of publication and mention of the grant of the patent: **28.11.2018**
(21) Application number: 12164617.8
(22) Date of filing: 18.04.2012
(51) Int. Cl.: F25B 21/02, H01L 35/30, F28D 15/02, F24F 5/00, B60H 1/00, F25B 25/00

(54) **Thermoelectric heat exchanger capable of providing two different discharge temperatures**
Thermoelektrischer Wärmetauscher mit Fähigkeit zur Bereitstellung zwei verschiedener Entladungstemperaturen
Échangeur de chaleur thermoélectrique capable de fournir deux températures de décharge différentes

(30) Priority: 25.04.2011 US 201161478660 P; 23.03.2012 US 201213428560
(43) Date of publication of application: 31.10.2012
(73) Proprietor: MAHLE International GmbH, 70376 Stuttgart (DE)
(72) Inventor: Kadle, Prasad Shripad, Williamsville, NY New York 14221 (US); Wang, Mingyu, Amherst, NY New York 14501 (US); Wolfe IV, Edward, Clarence Center, NY 14032 (US)
(74) Representative: BRP Renaud & Partner mbB Rechtsanwälte Patentanwälte Steuerberater

(56) References cited:
- DE-A1- 3 528 731
- JP-A- S6 317 325
- JP-A- H06 257 923
- JP-A- 2003 322 482
- US-A- 3 004 393
- US-A- 3 073 127
- US-A- 3 552 133
- US-A- 3 834 171
- US-A1- 2003 029 175
- US-A1- 2010 101 238

## Description

### TECHNICAL FIELD OF INVENTION

The present disclosure relates to a thermoelectric heat exchanger according to the preamble of claim 1, and to a heating, ventilation, and air conditioning system provided with such a heat exchanger.

### BACKGROUND OF INVENTION

Presently, the passenger compartment in a vehicle is typically cooled or heated by an air flow processed by a heating ventilation and air conditioning (HVAC) system. The HVAC system may be designed to provide cooling or heating to one or more zones in the passenger compartment to provide different temperature zones within the passenger compartment in order to optimize passenger comfort. A common example is to provide independent temperature control to the driver and front seat passenger seating areas.

Thermoelectric devices (TEDs), also known as thermoelectric coolers (TECs) or Peltier coolers, may be used in the HVAC system to provide warmed and or cooled air, especially in vehicles that may not provide an adequate supply of waste heat, such as electric or hybrid electric vehicles. A TED is a semiconductor-based device that upon application of an electric voltage becomes hot on one side and cold on the other side. A typical TED has the dimensions of approximately 40 millimeters (length) by 40 millimeters (width) by 4 millimeters (thickness). TEDs are available from a number of sources including Ferrotec (USA) Corporation of Santa Clara, California and Laird Technologies of Earth City, Missouri. The construction, design, and operation of TEDs are well known to those skilled in the art.

Because of the ability to provide heating and/or cooling, a TED may be used in a HVAC system to change the temperature of the air flow from the HVAC system. This may be especially beneficial for changing the temperature of a portion of the air flow that may be used for spot cooling or spot heating of areas within a vehicle passenger compartment.

A heat exchanger comprising thermoelectric devices in a HVAC system may present packaging difficulties. The capacity for heating or cooling provided by an individual TED is limited, therefore multiple TEDs are typically required to provide adequate heating or cooling. Because TEDs provide heating on one side and cooling on the other side of the device, an obvious solution for providing adequate capacity is by arranging TEDs in a two dimensional array. The length or width of the two dimensional array required can easily exceed the packaging space available in the HVAC system. An alternative packaging scheme is presented in German Offenlegungsschrift DE 10-2010-021-901-A1 by Walter et. al. Walter describes a one dimensional array of TEDs with a pair of serpentine ducts interwoven between the array of TEDs in such a manner that one duct is only in contact with the hot side of each TED and provides a warmed fluid stream and the other duct is only in contact with the cold side of each TED and provides a cooled fluid stream. The length of the one dimensional array required to produce adequate heating and cooling may also exceed the available packaging space in the HVAC system. In addition, the fabrication and assembly of the serpentine ducts would add undesirable complexity and cost to the heat exchanger.

JP H06-257923 A discloses a thermoelectric heat exchanger assembly of this type. Such a heat exchanger assembly is configured to heat a first portion of a fluid flowing through said assembly and cool a second portion of the fluid flowing through said assembly, wherein the first portion is segregated from the second portion. Such an assembly further comprises a first thermoelectric device configured to heat said first portion of the fluid; a second thermoelectric device configured to cool said second portion of the fluid. The known assembly further comprises heat pipes configured to transfer thermal energy between the first thermoelectric device and the second thermoelectric device via evaporation and condensation of a working fluid contained within the tubes. A similar thermoelectric heat exchanger assembly is also know from US 3,004,393.

### SUMMARY OF THE INVENTION

In the present invention, a thermoelectric heat exchanger assembly, in particular a cross-flow heat exchanger assembly is provided according to claim 1. The heat exchanger assembly is configured to heat a first portion of a fluid flowing through the assembly and cool a second portion of the fluid flowing through the assembly. The first portion of the fluid flowing through the assembly is segregated from the second portion of the fluid flowing through the assembly. The assembly includes a first TED configured to heat the first portion of the fluid flowing through the assembly and a second TED configured to cool the second portion of the fluid flowing through the assembly. The assembly further includes a first tube in thermal communication with the first TED and configured to contain a working fluid. The assembly additionally includes a second tube in thermal communication with the second TED and configured to contain the working fluid. The assembly also includes a first shell defining a first cavity that is oriented to contain the working fluid in a substantially liquid phase and a second shell defining a second cavity that is oriented to contain the working fluid in a substantially vapor phase. The first tube and the second tube are sealably coupled to the first shell and the second shell. The first cavity and the second cavity are in fluidic communication through the first tube and the second tube. The assembly is configured to transfer thermal energy between the first TED and the second TED through evaporation and condensation of the working fluid. The second tube may further contain a wicking material configured to transfer the working fluid contained in the first cavity to the first tube. The working fluid may circulate within the assembly via thermo-syphon action.

In yet another embodiment of the present invention, a heating, ventilation, and air conditioning (HVAC) system is provided. The heating, ventilation, and air conditioning system is configured to cool a first portion of an air stream flowing through the system and heat a second portion of the air stream flowing through the system. The first portion of the air stream flowing through the system is segregated from the second portion of the air stream flowing through the system. The system includes a heat exchanger assembly according to the invention, said assembly configured to change the temperature of the air stream flowing through the system. The system additionally may include a first plenum configured to segregate the air stream flowing through the system into the first portion of the air stream flowing through the system and a second plenum configured to segregate the air stream flowing through the system into the second portion of the air stream flowing through the system. The system further includes a first TED configured to heat the first portion of the air stream flowing through the system and cool the second portion of the air stream flowing through the system.

The HVAC system may additionally include a first fin disposed within the first plenum, a second fin disposed within the second plenum, and a second TED thermally coupled to the second fin and configured to cool the second portion of the air stream flowing through the system. The first TED may be thermally coupled to the first fin and may be configured to only heat the first portion of the air stream flowing through the system. The first TED may be thermally coupled to the second TED.

The HVAC system may further include a first plurality of fins disposed within the first plenum, a second plurality of fins disposed within the second plenum, a first plurality of TEDs coupled to the first plurality of fins and configured to heat the first portion, and a second plurality of TEDs coupled to the second plurality of fins and configured to cool the second portion. The first plurality of TEDs may be thermally coupled to the second plurality of TEDs.

The HVAC system further includes tubes configured to transfer thermal energy between the first TED and the second TED via evaporation and condensation of a working fluid contained within the tubes.

The HVAC system further includes a first tube in thermal communication with the first TED and configured to contain a working fluid, a second tube in thermal communication with the second TED and configured to contain the working fluid, a first shell defining a first cavity configured to contain the working fluid substantially in a liquid phase, and a second shell defining a second cavity configured to contain the working fluid substantially in a vapor phase. The first tube and the second tube are be sealably coupled to the first shell and the second shell. The first cavity and the second cavity are in fluidic communication through the first tube and the second tube. The system is configured to transfer thermal energy between the first TED and the second TED through evaporation and condensation of the working fluid.

Further features and advantages of the invention will appear more clearly on a reading of the following detailed description of the preferred embodiment of the invention, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a cutaway side view diagram of a vehicle equipped with an HVAC system including a thermoelectric heat exchanger in accordance with one example not part of the the invention;
Fig. 2 is a cutaway side view diagram of a stacked thermoelectric heat exchanger including a sealed thermoelectric heat exchanger as shown in Fig. 3 with a heating section and a cooling section in accordance with another example not part of the invention;
Fig. 3 is a cutaway side view diagram of a sealed thermoelectric heat exchanger including a heat pipe charged with working fluid in accordance with an example not part of the invention;
Fig. 4 is a cutaway side view diagram of a thermoelectric heat exchanger charged with a working fluid in accordance with the invention;
Fig. 5 is a cutaway side view diagram of a heating, ventilation, and air conditioning HVAC system including a thermoelectric heat exchanger in accordance with another embodiment;
Fig. 6 is a cutaway side view diagram of a HVAC system including a sealed thermoelectric heat exchanger as shown in Fig. 3 in accordance with an example not part of the invention;
Fig. 7 is a cutaway side view diagram of a HVAC system including a stacked thermoelectric heat exchanger as shown in Fig. 2 in accordance with an example not part of the invention; and
Fig. 8 is a cutaway top view diagram of a HVAC system including a thermoelectric heat exchanger as shown in Fig. 4 in accordance with another embodiment.

### DESCRIPTION OF THE PREFERRED EMBODIMENTS

Because thermoelectric devices (TEDs) provide heating on one side and cooling on the other side of the device, an obvious solution for providing adequate cooling and heating capacity is to arrange TEDs in a two dimensional array. The length or width of the two dimensional array required can easily exceed the packaging space available in a heating, ventilation, and air conditioning (HVAC) system. An alternative one dimensional array of TEDs is presented in German Offenlegungsschrift DE 10-2010-021-901-A1 which describes a pair of serpentine ducts interwoven between the array of TEDs in such a manner that one duct is only in contact with the hot side of each TED and provides a warmed fluid stream and the other duct is only in contact with the cold side of each TED and provides a cooled fluid stream. The length of the one dimensional array may also exceed the available packaging space in the HVAC system.

Instead of packaging TEDs in a heat exchanger in a one dimensional array as is shown in the prior art or an obvious two dimensional array, the TEDs may be arranged in a three dimensional array. Arranging the TEDs in a three dimensional array may provide a heat exchanger assembly that is more compact and thus easier to package within the confines of a HVAC system. The TEDs may be configured to cool a first portion of a fluid (as a non-limiting example, air) flowing through a cooling region of the assembly that is, for example directed toward one part of a person's body, and heat a second portion of the fluid flowing through a heating region of the assembly that is, for example directed toward another part of a person's body. The TEDs are preferably arranged so that one section of the heat exchanger cools the first portion of a fluid flowing through the assembly and another section of the heat exchanger heats the second portion of a fluid flowing through the assembly. The thermoelectric heat exchanger must be configured so that the thermal energy absorbed by the TEDs that are cooling the first portion of the fluid is transferred to the TEDs that are heating the second portion of the fluid.

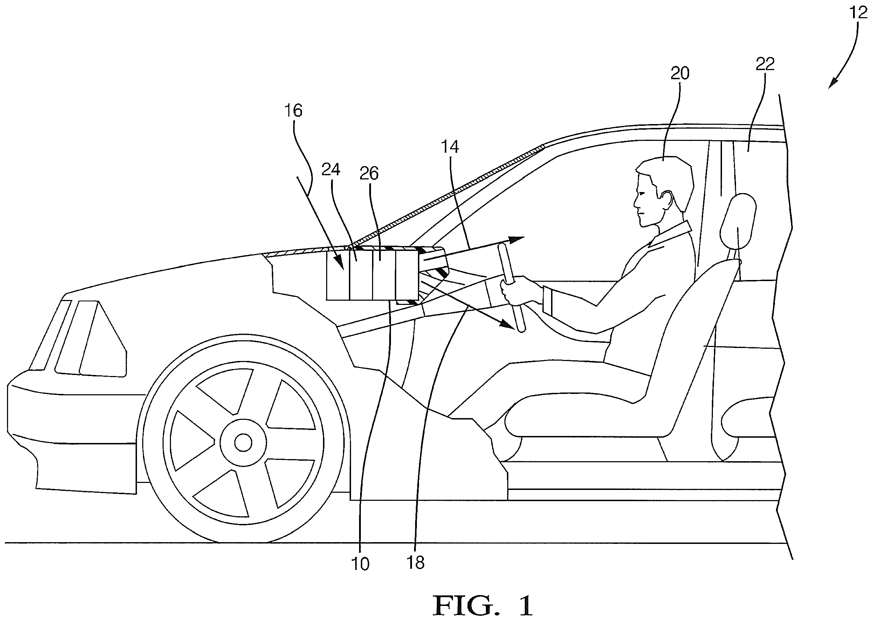

Fig. 1 illustrates a non-limiting example of heating, ventilation, and air conditioning (HVAC) system 10 that may be configured for use in a vehicle 12 to provide a first portion 14 of an air stream 16 for spot heating and a second portion 18 of the air stream 16 for spot cooling of a passenger 20 within the passenger compartment 22 of the vehicle 12. It is recognized that this independent heating and cooling could also be used to separately control the temperatures of the passenger 20 and an operator (not shown) of the vehicle 12.

The HVAC system 10 may include a conventional heat exchanger 24 (e.g. heater core or evaporator) in addition to a thermoelectric heat exchanger 26. The conventional heat exchanger 24 may be configured to provide a base output temperature and the thermoelectric heat exchanger 26 may be configured to increase and decrease the base output temperature to provide independent spot heating and spot cooling of separate parts of the body of the passenger 20. The thermoelectric heat exchanger 26 may be capable of providing air at two different discharge temperatures.

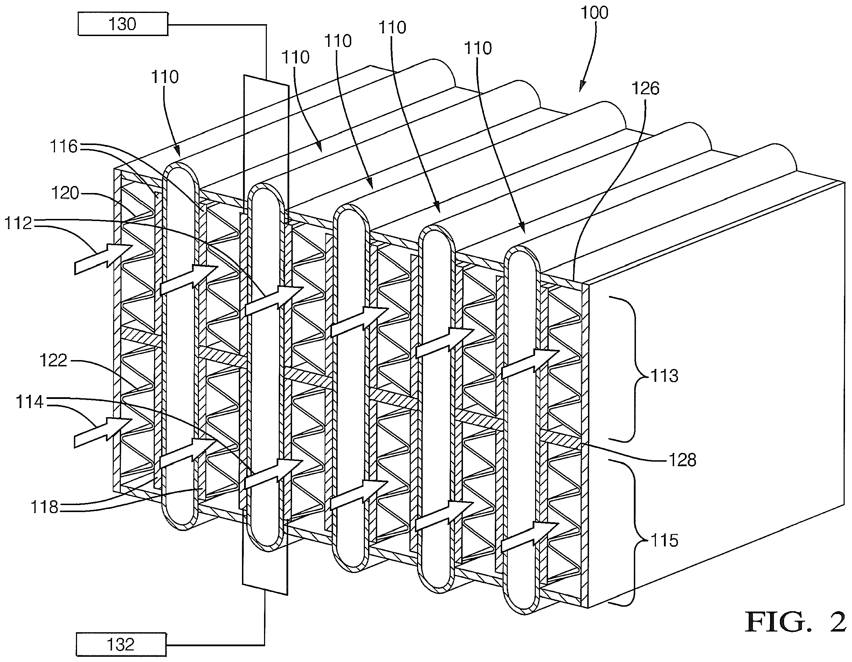

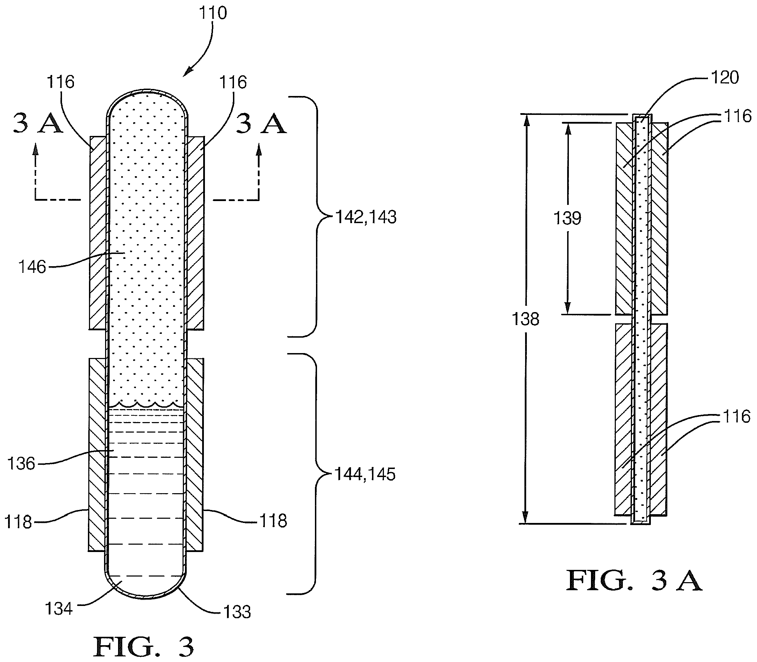

Fig. 2 illustrates a non-limiting example of a cross flow thermoelectric heat exchanger assembly 100 configured to heat a first portion 112 of a fluid flowing through a heating region 113 of the assembly 100 (the upper portion as shown in Fig. 2) and cool a second portion 114 of the fluid flowing through the a cooling region 115 assembly 100 (the lower portion as shown in Fig. 2). The assembly 100 includes of a plurality of thermoelectric assemblies 110 as shown in detail in Fig. 3 that include a plurality of first TEDs 116 and a plurality of second TEDs 118.

Fig. 3 illustrates a non-limiting example of the thermoelectric assembly 110. The thermoelectric assembly 110 includes the first thermoelectric device (TED) 116 that is configured to heat the first portion 112 of the fluid flowing through the assembly 100. The heat exchanger also includes the second TED 118 that is configured to cool the second portion 114 of the fluid flowing through the assembly 100.

The thermoelectric assembly 110 further includes a heat pipe 133 that is configured to transfer thermal energy between the first TED 116 and the second TED 118 via (i.e. using the mechanism of) evaporation and condensation of a working fluid 134 contained within a cavity 136 defined by the heat pipe 133.

The heat pipe 133 in this non-limiting example is a sealed pipe or tube. The heat pipe 133 may define an upper section 142 and a lower section 144. The heat pipe 133, as a non-limiting example, may have a rectangular cross section wherein the width 138 of the heat pipe 133 is preferably greater than the width 139 of the first TED 116 and the second TED 118. The thickness of the heat pipe 133 is preferably greater than 1.6 mm. The first TED 116 may be preferably located proximate to and thermally coupled to the upper section 142 of the heat pipe 133. The second TED 118 may be preferably located proximate to and thermally coupled to the lower section 144 of the heat pipe 133. The first TED 116 and the second TED 118 may be bonded to the heat pipe 133 by a thermally conductive adhesive, such as aluminum filled epoxy adhesive TC-2707 available from the 3M Company of Saint Paul, Minnesota.

The heat pipe 133 is preferably constructed of a material having a high thermal conductivity, such as copper or aluminum alloy for both the upper section 142 and the lower section 144. The heat pipe 133 forms a cavity 136 that is typically sealed at the top and bottom after it is charged with the working fluid 134. A vacuum pump is typically used to remove a large portion of air from the cavity 136, and then the cavity 136 is filled with a fraction of a percent by volume of working fluid 134 chosen to match the operating temperature of the assembly 100. Examples of suitable working fluids may include ethanol, acetone, 1,1,1,2-Tetrafluoroethane (refrigerant R134a), or 2,3,3,3-Tetrafluoropropene (refrigerant HFO-1234yf).

The heat pipe 133 employs evaporative cooling to transfer thermal energy from the lower portion to the upper portion by the evaporation and condensation of the working fluid 134. The heat pipe 133 relies on a temperature difference between the upper section 142 and the lower section 144 of the heat pipe 133 created by the operation of the first TED 116 and the second TED 118.

Without prescribing to any particular theory of operation, when the lower section 144 of the heat pipe 133 is heated by the thermal energy transferred from the second portion 114 of the fluid flowing through the assembly 100 by the second TED 118, the working fluid 134 inside the cavity 136 evaporates. The warmed vapor then rises to the upper section 142 and warms the upper section 142 of the heat pipe 133. The first TED 116 then transfers thermal energy from the vapor to the first portion 112 of the fluid flowing through the assembly 100. The first TED 116 also cools the upper section 142 of the heat pipe 133, thereby condensing the vapor back into a liquid working fluid 134.

Although a heat exchanger assembly could be constructed in a similar fashion to assembly 100 using a solid thermal conducting element, such as a copper plate, thermal energy transfer capability of the solid thermal conducting element is inferior to the heat pipe 133 of assembly 100.

The condensed working fluid 134 then flows back to the lower section 144 of the heat pipe 133. In the case of a vertically-oriented heat pipe 133, the condensed working fluid 134 may be moved from the upper section 142 to the lower section 144 by the force of gravity. In the case of horizontally oriented heat pipes, the cavity 136 of the heat pipe 133 may contain a wicking material 148 configured to transfer condensed vapor contained in a first segment 143 of the heat pipe 133 to a second segment 145 of the heat pipe 133 by capillary action. The construction, design, and utilization of heat pipes are well known to those skilled in the art.

The thermoelectric assembly 110 may preferably include a plurality of first TEDs 116 that are configured to heat the first portion 112 of the fluid flowing through the thermoelectric assembly 110 and a plurality of second TEDs 118 configured to cool the second portion 114 of the fluid flowing through the thermoelectric assembly 110. The plurality of first TEDs 116 and the plurality of second TEDs 118 may be arranged in a three dimensional array as shown in Fig. 3.

Referring once more to Fig. 2, the heat exchanger assembly 100 may include a plurality of first fins 120 are disposed between and thermally coupled to the plurality of first TEDs 116 and configured to be disposed within the first portion 112 of the fluid flowing through the assembly 100. The assembly 100 may also include a plurality of second fins 122 is disposed between and thermally coupled to the plurality of second TEDs 118 and configured to be disposed within the second portion 114 of the fluid flowing through the assembly 100. The plurality of first fins 120 and the plurality of second fins 122 are preferably constructed of a material having a high thermal conductivity, such as copper or aluminum alloys. The plurality of first fins 120 and plurality of second fins 122 may be serpentine fins or any other thermally conductive fin type commonly known in the art. The plurality of first fins 120 and the plurality of second fins 122 may be bonded to the thermal plates of the first TEDs 116 and the second TEDs 118 using a suitable adhesive, such as a thermally conductive epoxy resin adhesive such as such as an aluminum filled epoxy adhesive.

The plurality of first fins 120 and the plurality of second fins 122 provide the advantage improving thermal energy transfer between the plurality of first TEDs 116 and the first portion 112 of the fluid flowing through the assembly 100 and the plurality of second TEDs 118 and the second portion 114 of the fluid flowing through the assembly 100 by increasing the surface area exposed to the fluid flowing through the assembly 100.

The assembly 100 may further include a support structure 126 to support and locate the thermoelectric assemblies 110 within the assembly 100. The assembly 100 may additionally include a bulkhead 128 disposed between the plurality of first fins 120 and the plurality of second fins 122 that is configured to segregate the fluid flowing through the thermoelectric assembly 110 into the first portion 112 and the second portion 114. The bulkhead 128 is preferably constructed of a thermally non-conductive material, such as polypropylene to minimize the transfer of thermal energy from the first portion 112 of the fluid flowing through the thermoelectric assembly 110 to the second portion 114 of the fluid flowing through the thermoelectric assembly 110. Additionally, the bulkhead 128 may be configured to thermally isolate the first fin 120 from the second fin 122. The assembly 100 may alternatively contain a single thermoelectric assembly 110. The assembly 100 may alternatively contain a single first TED 116 and a single second TED 118. The assembly 100 may alternatively not include a plurality of first fins 120 or a plurality of second fins 122.

The assembly 100 may further include a first power supply 130 electrically coupled to the plurality of first TEDs 116 and a second power supply 132 electrically coupled to the plurality of second TEDs 118. A first voltage supplied by the first power supply 130 is different from and preferably of opposite polarity of a second voltage supplied by the second power supply 132. The first voltage and the second voltage may have the same voltage value but opposite polarity. The first power supply 130 and second power supply 132 is preferably configured to provide a direct current (DC) first voltage and second voltage. Alternatively, a single power supply may be coupled to both the plurality of first TEDs 116 and the plurality of second TEDs 118, wherein the first voltage applied to the first TED 116 is the same voltage value but opposite polarity of the second voltage applied to the second TED 118. Alternatively, a single power supply may be electrically coupled to the plurality of first TEDs 116 by a first pulse-width modulated (PWM) controller and may be electrically coupled the plurality of second TEDs 118 by a second PWM controller. The duty cycle of the first PWM controller may differ from the duty cycle of the second PWM controller in order to provide different effective voltages to the plurality of first TEDs 116 and the plurality of second TEDs 118.

Preferably the same first voltage is supplied to each of the plurality of first TEDs 116 and the same second voltage (albeit different from the first voltage) is supplied to each of the plurality of second TEDs 118. The assembly 100 may provide the advantage of producing two streams of air having different temperatures, wherein each stream of air has a generally uniform temperature distribution. Multiple heat exchanger assemblies 100 may be combined to provide multiple portions of cooled fluid and heated fluid, each at a different temperature by applying different voltages to the TEDs.

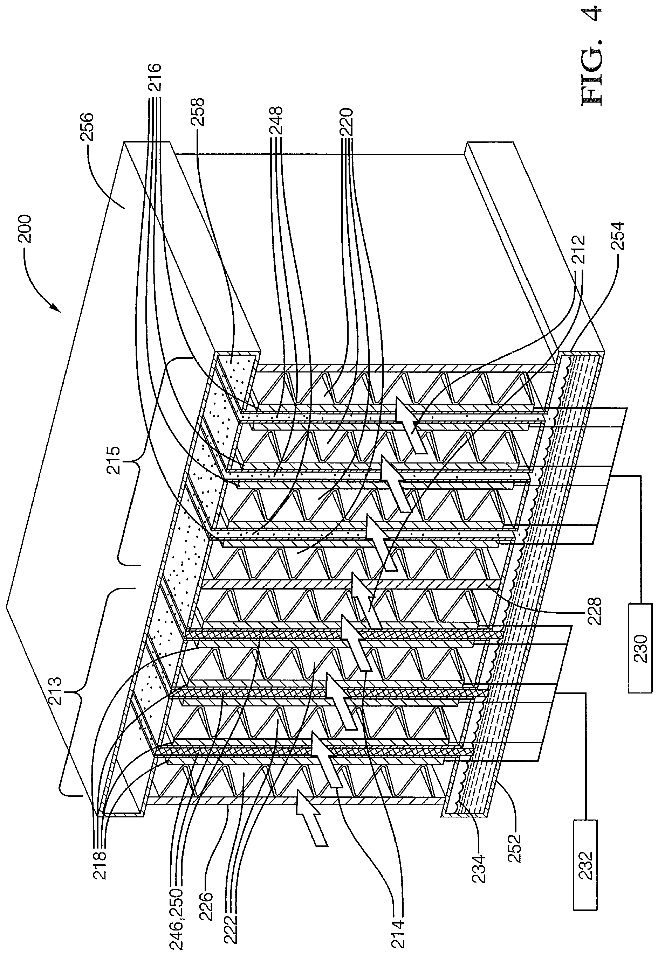

Fig. 4 illustrates another non-limiting example of a cross flow thermoelectric heat exchanger assembly 200 that is configured to heat a first portion 212 of a fluid flowing through a heating region 215 of the assembly 200 (the right side as shown in Fig. 4) and cool a second portion 214 of the fluid flowing through a cooling region 213 of the assembly 200 (the left side as shown in Fig. 4). The fluid flowing through the assembly 200 may be a liquid or a gas, such as air. The first portion 212 of the fluid flowing through the assembly 200 is segregated from the second portion 214 of the fluid flowing through the assembly 200. The heat exchanger assembly 200 includes a first TED 216 that is configured to heat the first portion 212 of the fluid flowing through the assembly 200. The heat exchanger also includes a second TED 218 configured to cool the second portion 214 of the fluid flowing through the assembly 200.

Alternatively, the first TED 216 may be configured to cool the first portion 212 of the fluid flowing through the assembly 200 and the second TED 218 may be configured to heat the second portion 214 of the fluid flowing through the assembly 200 by changing an electrical voltage applied to the first TED 216 and the second TED 218.

The assembly 200 further includes a first tube 248 that is in thermal communication with the first TED 216 and is configured to contain a working fluid 234 such as refrigerant R134a, or HFO-1234yf. The assembly 200 also includes a second tube 250 that is in thermal communication with the second TED 218 and is configured to contain the working fluid 234. The assembly 200 further includes a first shell 252 that defines a first cavity 254 oriented to contain the working fluid 234 in a substantially liquid phase. As used herein, the substantially liquid phase contains no more than 10 percent vapor. The assembly 200 additionally includes a second shell 256 that defines a second cavity 258 that is oriented to contain the working fluid 234 in a substantially vapor phase. As used herein, the substantially vapor phase contains no more than 10 percent liquid. The first tube 248 and the second tube 250 are sealably coupled to the first shell 252 and the second shell 256. The first cavity 254 and the second cavity 258 are in fluidic communication through the first tube 248 and the second tube 250. The assembly 200 is configured to transfer thermal energy between the first TED 216 and the second TED 218 through evaporation of the working fluid 234 in the second tube 250 and condensation of the working fluid 234 in the first tube 248.

The first shell 252, the second shell 256, the first tube 248 and the second tube 250 are preferably constructed of a material having a high thermal conductivity, such as copper or aluminum alloys. The first TED 216 and the second TED 218 may be bonded to the first tube 248 and the second tube 250 respectively using a thermally conductive adhesive, such as aluminum filled epoxy. The first tubes 248 and the second tubes 250 may be bonded to the first shell 252 and second shell 256 by braising or adhesive such as epoxy or methyl acrylate. Use of adhesives is preferable if the first TED 216 and the second TED 218 are bonded to the first tube 248 and the second tube 250 prior to assembling the first tubes 248 and the second tubes 250 to the first shell 252 and the second shell 256 due to concerns of damaging the first TED 216 or the second TED 218 due to the heat of braising. The assembly 200 may also include a support structure 226 to support and locate the first shell 252 and the second shell 256 within the assembly 200. The support structure 226 may also be configured to direct the first portion 212 and the second portion 214 of the fluid lowing through the assembly 200. The heat exchanger assembly 200 may be constructed using methods and designs for tube and shell heat exchangers that are well known to those skilled in the art.

The ends of the first tube 248 and the second tube 250 are not sealed, but are fluidicly coupled to the first cavity 254 of the first shell 252 and the second cavity 258 of the second shell 256. The ends of the first tube 248 and second tube 250 are disposed in the first cavity 254 of the first shell 252 and the second cavity 258 of the second shell 256 at both ends of the heat exchanger. The assembly 200 may be divided horizontally into two sections by a thermally insulating bulkhead 228.

The end of the first tube 248 that is disposed in the first cavity 254 may be submerged in the working fluid 234 which is in a substantially liquid state. The second tube 250 may contain a wicking material 246. Without prescribing to any particular theory of operation, as the liquid working fluid 234 is wicked into the second tube 250, the second TED 218 transfers heat energy from the second portion 214 of the fluid flowing through the assembly 200 to the working fluid 234. In the process, the liquid working fluid 234 is boiled thus forming a vapor. Convection causes the vapor to flow through the second tube 250 to the end of the second tube 250 that is disposed in the second cavity 258, thereby discharging the vapor into the second cavity 258.

The wicking material 246 provides the advantage of drawing liquid working fluid 234 into the second tube 250 which increases the amount of working fluid 234 in the second tube 250 that is available to absorb thermal energy from the second TED 218. Without the wicking material 246, the liquid working fluid 234 may contact the second tube 250 only where the end of the second tube 250 extends into the first cavity 254 of the first shell 252, providing very little surface area for the liquid working fluid 234 to contact the second tube 250.

The vapor in the second cavity 258 contacts the end of the first tube 248 that is disposed in the second cavity 258. Because the first TED 216 is transferring heat energy from the working fluid 234 to the first portion 212 of the fluid flowing through the assembly 200, the first TED 216 cools the first tube 248. As vapor flows into the first tube 248 and is exposed to the cold sides of the first tube 248, it condenses into liquid working fluid 234. The liquid working fluid 234 may flow through the first tube 248 to the end of the first tube 248 that is disposed in the first cavity 254 and into the first cavity 254 under the influence of gravity, thus completing a cycle for the working fluid 234. The working fluid 234 may circulate within the assembly 200 via convection or thermo-syphon action. Alternatively, the first tube 248 may also contain wicking material to return condensed working fluid 234 to the first cavity 254 via capillary action.

As shown in Fig. 4, the assembly 200 may further include a first thermally conductive fin 220 that is thermally coupled to the first TED 216 and is disposed within the first portion 212 of the fluid flowing through the assembly 200. The assembly 200 may also include a second thermally conductive fin 222 that is thermally coupled to the second TED 218 and disposed within the second portion 214 of the fluid flowing through the assembly 200. The first fin 220 and the second fin 222 are preferably constructed of a material having a high thermal conductivity, such as copper or aluminum alloys. The first fin 220 and second fin 222 may be serpentine fins or any other thermally conductive fin type commonly known in the art. The first fin 220 and the second fin 222 may be bonded to the thermal plates of the first TED 216 and the second TED 218 respectively using a suitable adhesive, such as a thermally conductive epoxy resin adhesive such as such as an aluminum filled epoxy adhesive.

The first fins 220 and the second fins 222 provide the advantage improving thermal energy transfer between the first TED 216 and the first portion 212 of the fluid flowing through the assembly 200 and the second TED 218 and the second portion 214 of the fluid flowing through the assembly 200 by increasing the surface area exposed to the fluid flowing through the assembly 200.

The bulkhead 228 may be disposed between the first fin 220 and the second fin 222 to segregate the fluid flowing through the assembly 200 into the first portion 212 and the second portion 214. The bulkhead 228 is preferably constructed of a thermally non-conductive material, such as polypropylene to minimize the transfer of thermal energy from the first portion 212 of the fluid flowing through the assembly 200 to the second portion 214 of the fluid flowing through the assembly 200. Additionally, the bulkhead 228 may be configured to thermally isolate the first fin 220 from the second fin 222.

The assembly 200 may further include a first power supply 230 electrically coupled to the first TED 216 and a second power supply 232 electrically coupled to the second TED 218. A first voltage supplied by the first power supply 230 is different from and preferably of opposite polarity of a second voltage supplied by the second power supply 232. The first voltage and the second voltage may have the same voltage value but opposite polarity. The first power supply 230 and the second power supply 232 are preferably configured to provide a direct current (DC) first voltage and second voltage. Alternatively, a single power supply may be coupled to both the first TED 216 and the second TED 218, wherein the first voltage applied to the first TED 216 is the same voltage value but opposite polarity of the second voltage applied to the second TED 218.

The assembly 200 may additionally include a plurality of first TEDs 216 that are configured to heat the first portion 212 of the fluid flowing through the assembly 200 and a plurality of second TEDs 218 that are configured to cool the second portion 214 of the fluid flowing through the assembly 200. The assembly 200 may further includes a plurality of first tubes 248 that is in thermal communication with the plurality of first TEDs 216 and a plurality of second tubes 250 that is in thermal communication with the plurality of second TEDs 218. The assembly 200 may further include a plurality of first fins 220 that are thermally coupled to the plurality of first TEDs 216 and are disposed within the first portion 212 of the fluid flowing through the assembly 200 and a plurality of second fins 222 that are thermally coupled to the plurality of second TEDs 218 and disposed within the second portion 214 of the fluid flowing through the assembly 200. The plurality of first TEDs 216 may be arranged on each outer surface of the plurality of first tubes 248 in a two dimensional array. Likewise, the plurality of second TEDs 218 may be arranged on each outer surface of the plurality of second tubes 250 in a two dimensional array.

The plurality of first TEDs 216 may be connected to a common first power supply 230 having a first voltage. Each TED in the plurality of first TEDs 216 has the same electrical polarity. The plurality of first TEDs 216 may be arranged proximate to the first tube 248 in such a manner so as to provide cooling to the working fluid 234 inside the first tube 248.

Similarly, the plurality of second TEDs 218 may be connected to a common second power supply 232 having a second voltage. Each TED and in the plurality of second TEDs 218 has the same electrical polarity and the second voltage is the opposite polarity of the first voltage. The plurality of second TEDs 218 may be arranged proximate to the second tube 250 in such a manner so as to provide heating to the working fluid 234 inside the second tube 250. The assembly 200 may provide the advantage of producing two streams of air having different temperatures, each streams of air having a generally uniform temperature distribution. Multiple heat exchanger assemblies 200 may be combined to provide multiple portions of cooled fluid and heated fluid, each at a different temperature.

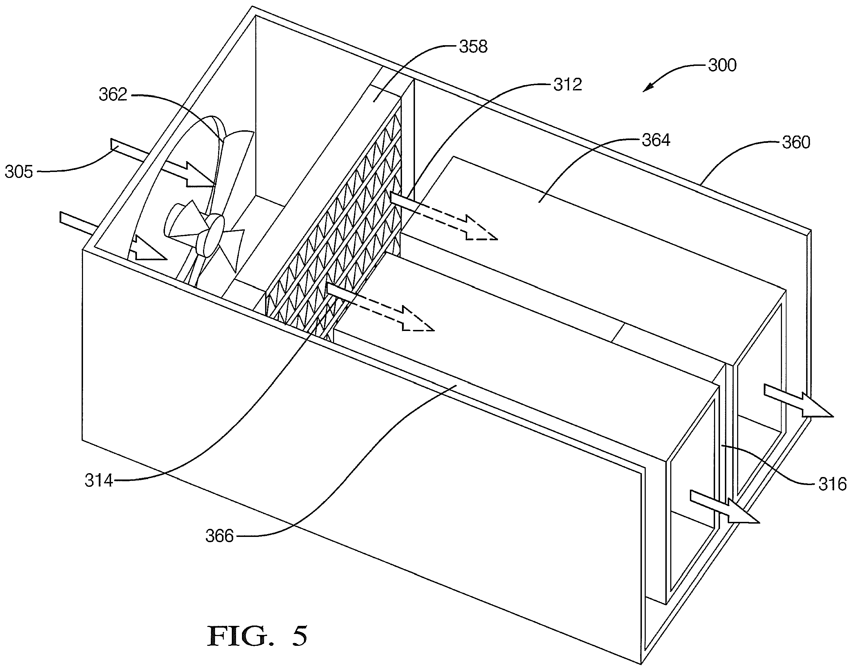

Fig. 5 illustrates a non-limiting example of another embodiment of a thermoelectric heating, ventilation, and air conditioning (HVAC) system 300 configured to cool a first portion 312 of an air stream 305 flowing through the system 300 and heat a second portion 314 of the air stream 305 flowing through the system 300. The first portion 312 of the air stream 305 flowing through the system 300 is segregated from the second portion 314 of the air stream 305 flowing through the system 300.

The system 300 includes a heat exchanger assembly 358 configured to change the temperature of the air stream 305 flowing through the system 300. The heat exchanger may be configured to heat the air stream 305 flowing through the system 300, such as a heater core used in internal combustion engine powered vehicle that provides waste heat from the engine's coolant. Alternatively, the heat exchanger may be configured to cool the air stream 305 flowing through the system 300, such as an evaporator used in a refrigeration system or an air conditioning system. The system 300 may include two heat different exchangers, one configured to heat the air stream 305 and one configured to cool the air stream 305 flowing through the system 300. The system 300 may preferably include a housing 360 to contain the airflow through the system 300. The system 300 may also preferably include a fan 362 or other air moving device to force the air flow through the system 300.

The system 300 also includes a first plenum 364 configured to segregate the air stream 305 flowing through the system 300 into the first portion 312 of the air stream 305 flowing through the system 300 and a second plenum 366 configured to segregate the air stream 305 flowing through the system 300 into the second portion 314 of the air stream 305 flowing through the system 300.

The system 300 further includes a first TED 316 configured to heat the first portion 312 of the air stream 305 flowing through the system 300 and cool the second portion 314 of the air stream 305 flowing through the system 300. The first TED 316 may be disposed intermediate to the first plenum 364 and the second plenum 366. The design and construction methods of HVAC system housings, air movement devices, heater cores, evaporators, and plenums are well known to those skilled in the art.

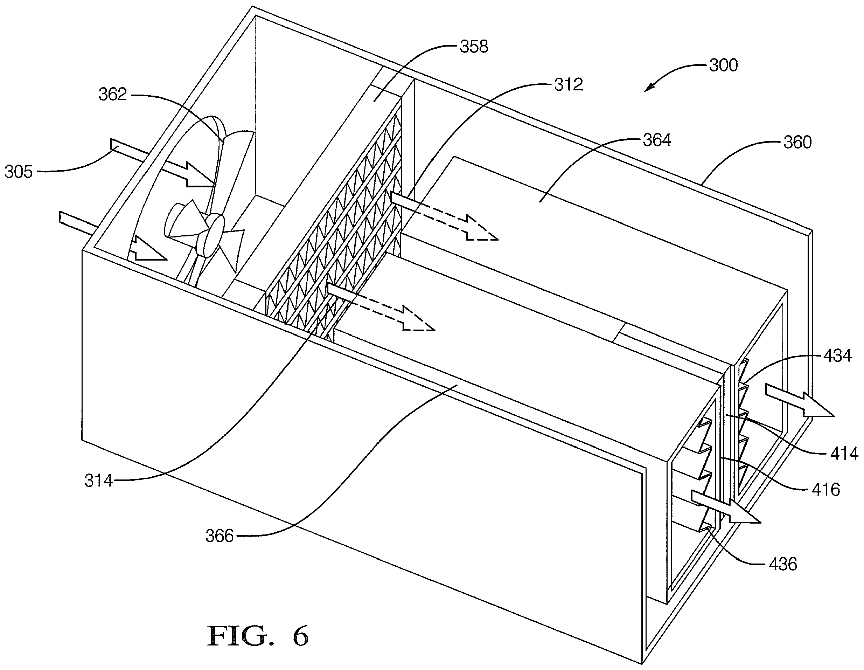

Fig. 6 illustrates a non-limiting example the system 300 wherein the system 300 may include a first fin 434 disposed within the first plenum 364 and a second fin 436 disposed within the second plenum 366. The system 300 may further include a second TED 416 that is thermally coupled to the second fin 436 and configured to cool the second portion 314 of the air stream 305 flowing through the system 300. The first TED 316 may be coupled to the first fin 434 and may be configured to only heat. The first TED 316 may be thermally coupled to the second TED 416.

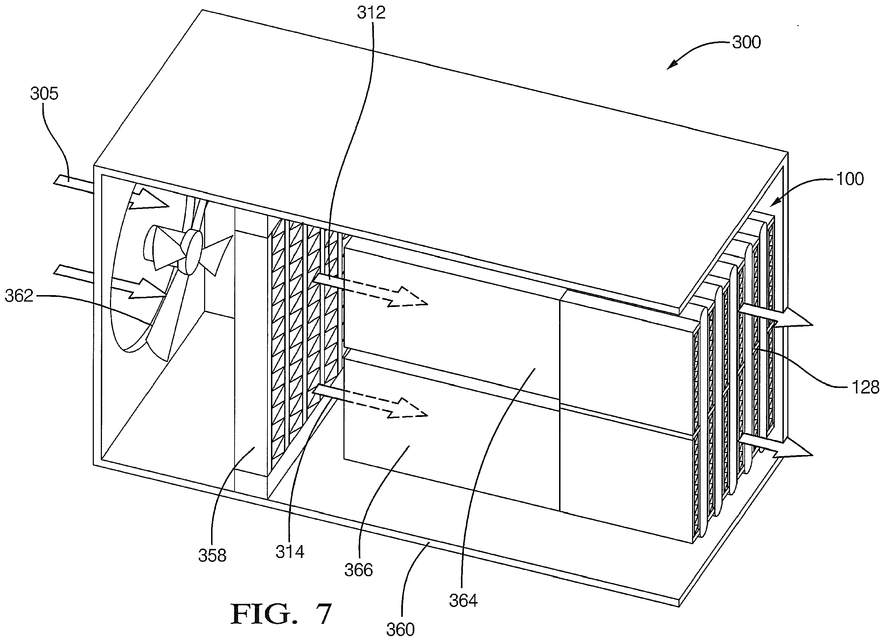

Fig. 7 illustrates a non-limiting example of the system 300 wherein the system 300 includes the assembly 100 as shown in Fig. 2. The first plenum 364 is configured to direct the first portion 312 of the air stream 305 flowing through the system 300 through the upper portion of the assembly 100. The second plenum 366 is configured to direct the second portion 314 of the air stream 305 flowing through the system 300 through the lower portion of the assembly 100.

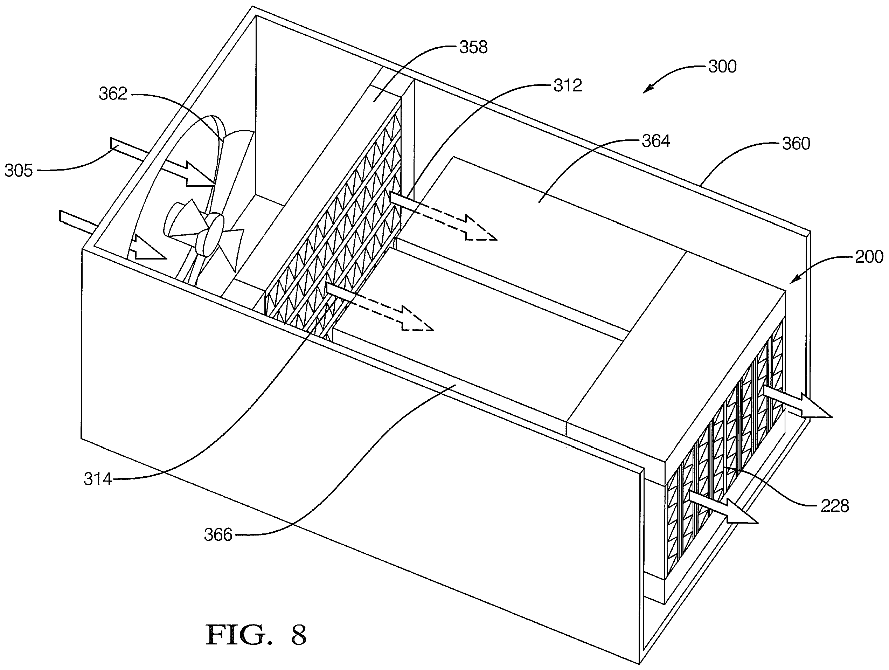

Fig. 8 illustrates a non-limiting example of another embodiment of the system 300 wherein the system 300 includes the assembly 200 as shown in Fig. 4. The first plenum 364 is configured to direct the first portion 312 of the air stream 305 flowing through the system 300 through the right side of the assembly 200. The second plenum 366 is configured to direct the second portion 314 of the air stream 305 flowing through the system 300 through the left side of the assembly 200.

Accordingly, a heat exchanger assembly 100, 200 and a heating, ventilation, and air conditioning (HVAC) system 300 is provided. The heat exchanger assembly 100, 200 may be configured to provide both heating and cooling of a fluid stream, such as air, flowing through the assembly 100, 200. The assembly 100, 200 may provide a compact thermoelectric heat exchanger that may be easier to package, for example in a HVAC system, due to arrangement of the thermoelectric devices 116, 118, 216, 218 in a three dimensional array within the heat exchanger assembly 100, 200. The inclusion of a working fluid 134, 234 within the assembly 100, 200 enhances the transfer of thermal energy between the first TED 116, 216 and the second TED 118, 218. The heat exchanger assembly 100, 200 may be used in electric or hybrid electric vehicles where conventional sources of heating and cooling are not readily available. In addition, the assembly 200 may be constructed using many of the design elements and methods of a conventional heat exchanger assembly.

The HVAC system 300 may utilize a thermoelectric heat exchanger assembly to provide streams of heated and cooled air for spot cooling and spot heating of a passenger 20 in a passenger compartment 22 of a vehicle 12. Several spot cooling and spot heating air streams may be needed to meet passenger comfort requirements. Different part of the body of the passenger 20 also requires different air temperatures. A HVAC system 300 of the design shown in Figs. 5 through 8 should meet the discharge temperature requirement for spot cooling and heating.

While this invention has been described in terms of the preferred embodiments thereof, it is not intended to be so limited, but rather only to the extent set forth in the claims that follow. Moreover, the use of the terms first, second, etc. does not denote any order of importance, but rather the terms first, second, etc. are used to distinguish one element from another. Furthermore, the use of the terms a, an, etc. do not denote a limitation of quantity, but rather denote the presence of at least one of the referenced items.

## Claims

1. A thermoelectric heat exchanger assembly (100, 200) configured to heat a first portion (112, 212) of a fluid flowing through said assembly (100, 200) and cool a second portion (114, 214) of the fluid flowing through said assembly (100, 200), wherein the first portion (112, 212) is segregated from the second portion (114, 214), said assembly (100, 200) comprising:
a first thermoelectric device (116, 216) configured to heat said first portion (112, 212) of the fluid; and
a second thermoelectric device (118, 218) configured to cool said second portion (114, 214) of the fluid;
**characterized in**
**that** said assembly further comprises tubes (248, 250) configured to transfer thermal energy between the first thermoelectric device (116, 216)) and the second thermoelectric device (118, 218) via evaporation and condensation of a working fluid contained within the tubes (248, 250); and
**that** said tubes (248, 250) comprise:
a first tube (248) in thermal communication with the first thermoelectric device (216) and configured to contain a working fluid;
a second tube (250) in thermal communication with the second thermoelectric device (218) and configured to contain the working fluid;
wherein the assembly (200) further comprises:
a first shell (252) defining a first cavity (254) oriented to contain the working fluid in a substantially liquid phase;
a second shell (256) defining a second cavity (258) oriented to contain the working fluid in a substantially vapor phase,
wherein the first tube (248) and the second tube (250) are sealably coupled to the first shell (252) and the second shell (256), and wherein the first cavity (254) and the second cavity (258) are in fluidic communication through the first tube (248) and the second tube (250).

2. The assembly (100, 200) of claim 1, wherein the assembly further comprises:
a first fin (120, 220) thermally coupled to the first thermoelectric device (116, 216) and disposed within said first portion (112, 212) of the fluid; and
a second fin (122, 222) thermally coupled to the second thermoelectric device (118, 218) and disposed within said second portion (114, 214) of the fluid.

3. The assembly (100, 200) of claim 2, wherein the assembly further comprises:
a bulkhead (128, 228) disposed between the first fin (120, 220) and the second fin (122, 222) configured to segregate said first portion (112, 212) and said second portion (114, 214).

4. The assembly (100, 200) according to any one of the preceding claims, wherein the assembly further comprises:
a first power supply (130, 230) electrically coupled to the first thermoelectric device (116, 216); and
a second power supply (132, 232) electrically coupled to the second thermoelectric device (118, 218), wherein a first voltage supplied by the first power supply (130, 230) is different from a second voltage supplied by the second power supply (132, 232).

5. The assembly (200) to any one of the preceding claims, wherein the second tube (250) further contains a wicking material (246) configured to transfer the working fluid contained in the first cavity (254) to the first tube (248).

6. The assembly (200) to any one of the preceding claims, wherein the working fluid circulates within the assembly (200) via thermo-syphon action.

7. A heating, ventilation, and air conditioning (HVAC) system (300) configured to heat a first portion (312) of an air stream (305) flowing through said system (300) and cool a second portion (314) of the air stream (305) flowing through said system (300), wherein the first portion (312) is segregated from the second portion (314), said system (300) comprising a heat exchanger assembly (100, 200) according to anyone of the preceding claims, said assembly (100, 200) being configured to change the temperature of said air stream (305) flowing through said system (300).

## Patentansprüche

1. Thermoelektrische Wärmetauscherbaugruppe (100, 200), die eingerichtet ist, um einen ersten Abschnitt (112, 212) eines Fluids, das durch die Baugruppe (100, 200) strömt, zu heizen, und einen zweiten Abschnitt (114, 214) des Fluids, das durch die Baugruppe (100, 200) strömt, zu kühlen, wobei der erste Abschnitt (112, 212) von dem zweiten Abschnitt (114, 214) getrennt ist, wobei die Baugruppe (100, 200) umfasst:
eine erste thermoelektrische Vorrichtung (116, 216), die eingerichtet ist, um den ersten Abschnitt (112, 212) des Fluids zu heizen; und
eine zweite thermoelektrische Vorrichtung (118, 218), die eingerichtet ist, um den zweiten Abschnitt (114, 214) des Fluids zu kühlen;
**dadurch gekennzeichnet,**
**dass** die Baugruppe weiter Rohre (248, 250) umfasst, die eingerichtet sind, um Wärmeenergie mittels Verdampfung und Kondensierung eines innerhalb der Rohre (248, 250) enthaltenen Arbeitsfluids zwischen der ersten thermoelektrischen Vorrichtung (116, 216) und der zweiten thermoelektrischen Vorrichtung (118, 218) zu übertragen, und
**dass** die Rohre (248, 250) umfassen:
ein erstes Rohr (248), das in Wärmekommunikation mit der ersten thermoelektrischen Vorrichtung (216) steht und eingerichtet ist, um ein Arbeitsfluid zu enthalten;
ein zweites Rohr (250), das in Wärmekommunikation mit der zweiten thermoelektrischen Vorrichtung (218) steht und eingerichtet ist, um das Arbeitsfluid zu enthalten;
wobei die Baugruppe (200) weiter umfasst:
eine erste Schale (252), die einen ersten Hohlraum (254) definiert, der orientiert ist, um das Arbeitsfluid in einer im wesentlichen flüssigen Phase zu enthalten;
eine zweite Schale (256), die einen zweiten Hohlraum (258) definiert, der orientiert ist, um das Arbeitsfluid in einer im wesentlichen dampfförmigen Phase zu enthalten,
wobei das erste Rohr (248) und das zweite Rohr (250) abdichtbar mit der ersten Schale (252) und der zweiten Schale (256) gekoppelt sind, und wobei der erste Hohlraum (254) und der zweite Hohlraum (258) durch das erste Rohr (248) und das zweite Rohr (250) in fluidischer Kommunikation stehen.

2. Baugruppe (100, 200) nach Anspruch 1, wobei die Baugruppe weiter umfasst:
eine erste Finne (120, 220), die mit der ersten thermoelektrischen Vorrichtung (116, 216) thermisch gekoppelt und innerhalb des ersten Abschnitts (112, 212) des Fluids angeordnet ist; und
eine zweite Finne (122, 222), die mit der zweiten thermoelektrischen Vorrichtung (118, 218) thermisch gekoppelt und innerhalb des zweiten Abschnitts (114, 214) des Fluids angeordnet ist.

3. Baugruppe (100, 200) nach Anspruch 2, wobei die Baugruppe weiter umfasst:
eine Wandung (128, 228), die zwischen der ersten Finne (120, 220) und der zweiten Finne (122, 222) angeordnet und eingerichtet ist, um den ersten Abschnitt (112, 212) und den zweiten Abschnitt (114, 214) zu trennen.

4. Baugruppe (100, 200) nach einem der vorstehenden Ansprüche, wobei die Baugruppe weiter umfasst:
eine erste Stromversorgung (130, 230), die mit der ersten thermoelektrischen Vorrichtung (116, 216) elektrisch gekoppelt ist; und
eine zweite Stromversorgung (132, 232), die mit der zweiten thermoelektrischen Vorrichtung (118, 218) elektrisch gekoppelt ist, wobei eine erste Spannung, die von der ersten Stromversorgung (130, 230) bereitgestellt wird, sich von einer zweiten Spannung, die von der zweiten Stromversorgung (132, 232) bereitgestellt wird, unterscheidet.

5. Baugruppe (200) nach einem der vorstehenden Ansprüche, wobei das zweite Rohr (250) weiter ein Dochtmaterial (246) umfasst, das eingerichtet ist, um das in dem ersten Hohlraum (254) enthaltene Arbeitsfluid zu dem ersten Rohr (248) zu übertragen.

6. Baugruppe (200) nach einem der vorstehenden Ansprüche, wobei das Arbeitsfluid innerhalb der Bautruppe (200) mittels Thermosyphonwirkung zirkuliert.

7. Heiz-, Lüftungs-, und Klimatisierungssystem (HVAC) (300), das eingerichtet ist, um einen ersten Abschnitt (312) eines Luftstroms (305), der durch das System (300) strömt, zu heizen, und einen zweiten Abschnitt (314) des Luftstroms (305), der durch das System (300) strömt, zu kühlen, wobei der erste Abschnitt (312) von dem zweiten Abschnitt (314) getrennt ist, wobei das System (300) eine Wärmetauscherbaugruppe (100, 200) nach einem der vorstehenden Ansprüche umfasst, wobei die Baugruppe (100, 200) eingerichtet ist, um die Temperatur des Luftstroms (305), der durch das System (300) strömt, zu ändern.

## Revendications

1. Ensemble échangeur de chaleur thermoélectrique (100, 200) configuré pour chauffer une première portion (112, 212) d'un fluide s'écoulant à travers ledit ensemble (100, 200) et pour refroidir une seconde portion (114, 214) du fluide s'écoulant à travers ledit ensemble (100, 200), dans lequel la première portion (112, 212) est isolée de la seconde portion (114, 214), ledit ensemble (100, 200) comprenant :
un premier dispositif thermoélectrique (116, 216) configuré pour chauffer ladite première portion (112, 212) du fluide ; et
un second dispositif thermoélectrique (118, 218) configuré pour refroidir ladite seconde portion (114, 214) du fluide ;
**caractérisé**
**en ce que** ledit ensemble comprend en outre des tubes (248, 250) configurés pour transférer de l'énergie thermique entre le premier dispositif thermoélectrique (116, 216) et le second dispositif thermoélectrique (118, 218) par évaporation et condensation d'un fluide de travail contenu à l'intérieur des tubes (248, 250) ; et
**en ce que** lesdits tubes (248, 250) comprennent :
un premier tube (248) en communication thermique avec le premier dispositif thermoélectrique (216) et configuré pour contenir un fluide de travail ;
un second tube (250) en communication thermique avec le second dispositif thermoélectrique (218) et configuré pour contenir le fluide de travail ;
dans lequel l'ensemble (200) comprend en outre :
une première enveloppe (252) définissant une première cavité (254) orientée pour contenir le fluide de travail sensiblement dans une phase liquide ;
une seconde enveloppe (256) définissant une seconde cavité (258) orientée pour contenir le fluide de travail sensiblement dans une phase vapeur,
dans lequel le premier tube (248) et le second tube (250) sont reliés de manière étanche à la première enveloppe (252) et à la seconde enveloppe (256), et dans lequel la première cavité (254) et la seconde cavité (258) sont en communication fluidique par l'intermédiaire du premier tube (248) et du second tube (250).

2. Ensemble (100, 200) selon la revendication 1, dans lequel l'ensemble comprend en outre :
une première ailette (120, 220) thermiquement couplée au premier dispositif thermoélectrique (116, 216) et disposée à l'intérieur de ladite première portion (112, 212) du fluide ; et
une seconde ailette (122, 222) thermiquement couplée au second dispositif thermoélectrique (118, 218) et disposée à l'intérieur de ladite seconde portion (114, 214) du fluide.

3. Ensemble (100, 200) selon la revendication 2, dans lequel l'ensemble comprend en outre :
une cloison (128, 228) disposée entre la première ailette (120, 220) et la seconde ailette (122, 222) configurée pour isoler ladite première portion (112, 212) et ladite seconde portion (114, 214).

4. Ensemble (100, 200) selon l'une quelconque des revendications précédentes, dans lequel l'ensemble comprend en outre :
une première alimentation en énergie (130, 230) électriquement couplée au premier dispositif thermoélectrique (116, 216) ; et
une seconde alimentation en énergie (132, 232) électriquement couplée au second dispositif thermoélectrique (118, 218), dans laquelle une première tension fournie par la première alimentation en énergie (130, 230) diffère d'une seconde tension fournie par la seconde alimentation en énergie (132, 232).

5. Ensemble (200) selon l'une quelconque des revendications précédentes, dans lequel le second tube (250) contient en outre une matière d'aspiration capillaire (246) configurée pour transférer le fluide de travail contenu dans la première cavité (254) au premier tube (248).

6. Ensemble (200) selon l'une quelconque des revendications précédentes, dans lequel le fluide de travail circule à l'intérieur de l'ensemble (200) par une action de thermosiphon.

7. Système de chauffage, de ventilation et de climatisation (HVAC) (300) configuré pour chauffer une première portion (312) d'une colonne d'air (305) s'écoulant à travers ledit système (300) et refroidir une seconde portion (314) de la colonne d'air (305) s'écoulant à travers ledit système (300), dans lequel la première portion (312) est isolée de la seconde portion (314), ledit système (300) comprenant un ensemble échangeur de chaleur (100, 200) selon l'une quelconque des revendications précédentes, ledit ensemble (100, 200) étant configuré pour changer la température de ladite colonne d'air (305) s'écoulant à travers ledit système (300).
